(19) Europäisches Patentamt
European Patent Office
Office européen des brevets

(11) Publication number: **0 230 328 B1**

# (12) EUROPEAN PATENT SPECIFICATION

(45) Date of publication of patent specification: **23.10.91** (51) Int. Cl.[5]: **C08G 59/62**, C08G 59/68

(21) Application number: **87200018.7**

(22) Date of filing: **07.01.87**

## (54) Epoxy resin composition.

(30) Priority: **21.01.86 US 820780**

(43) Date of publication of application:
**29.07.87 Bulletin 87/31**

(45) Publication of the grant of the patent:
**23.10.91 Bulletin 91/43**

(84) Designated Contracting States:
**BE CH DE FR GB IT LI NL**

(56) References cited:
**DE-A- 3 131 412**
**FR-A- 2 337 752**

**PATENT ABSTRACTS OF JAPAN, vol. 10, no. 136 (C-347)[2193], 20th May 1986; JP-A-60 260 618 (TOSHIBA CHEMICAL K.K.) 23-12-1985**

**PATENT ABSTRACTS OF JAPAN, vol. 9, no. 28 (C-264)[1751], 6th February 1985; & JP-A-59 174 617 (TOSHIBA K.K.) 03-10-1984**

(73) Proprietor: **SHELL INTERNATIONALE RESEARCH MAATSCHAPPIJ B.V.**
**Carel van Bylandtlaan 30**
**NL-2596 HR Den Haag(NL)**

(72) Inventor: **Conway, Michael Francis**
**7111 Santa Rita Drive**
**Houston Texas 77083(US)**
Inventor: **Young, Glenda Carole**
**7130 Aragon Drive**
**Houston Texas 77083(US)**
Inventor: **Corley, Larry Steven**
**6807 San Pablo Drive**
**Houston Texas 77083(US)**

(74) Representative: **Tuijn, Jan Warnaar et al**
**Shell Internationale Research Maatschappij B.V., Patents, Licensing & Trade Marks Division, P.O. Box 302**
**NL-2501 CH The Hague(NL)**

**EP 0 230 328 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The invention relates to curable epoxy resin compositions which are particularly suitable for electrical laminate applications. For laminating purposes, the resin system should not be subject to exotherming at high temperatures. The cured laminate resin must have a high glass transition temperature to withstand high operating temperatures sustained by some circuit boards. It must have a low thermal coefficient of expansion to ensure dimensional stability of the circuit board under operating temperatures. It is also desirable, for high-performance applications, that the laminate has flame-retardant properties.

According to the invention these criteria are met by compositions comprising

(a) an epoxy resin having an average functionality of from 3 to 6;

(b) a curing amount of a resorcinol novolac resin;

(c) a catalytic amount of a urea compound described by the formula

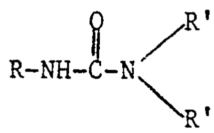

in which R is an aromatic or aliphatic moiety and each R' is selected independently from $C_1$-$C_{20}$ alkyl and aromatic;

(d) a halogenated epoxy resin having an average functionality of from 2 to 3;

(e) a halogenated bisphenol.

The epoxy resin having a functionality of from 3 to 6, preferably from 3.5 to 4.5 is most suitably a polyglycidyl ether of a multifunctional phenol having an epoxide equivalent weight of from 85 to 300. Preferable multifunctional epoxy resins are tetrafunctional polyglycidyl ethers of tetrakis(hydroxyphenyl)-ethane with an epoxide equivalent weight of from 210 to 240. These are available commercially as EPIKOTE 1031. The epoxy resin component (a) will generally be present in the composition in an amount of from 20 to 60 weight per cent (%w), preferably from 30 to 50 %w, based on the weight of total composition.

Component (d) is suitably a polyglycidyl ether of a tetrahalobisphenol-A, preferably tetrabromobisphenol-A or a mixture of tetrabromobisphenol-A and bisphenol-A; the epoxide equivalent will generally be from 350 to 600, preferably from 370 to 430. Component (d) will generally be present in the composition in an amount effective to bring the total halogen content from 10 to 20 %w, based on the weight of total composition of this invention.

Component (e) is preferably tetrabromobisphenol-A. This component is present in an amount of up to 30 %w, preferably 2 to 10 %w, based on the weight of total composition of this invention.

The resorcinol novolac curing resin (b) is selected from resinous materials prepared by reacting resorcinol with formaldehyde in acid solution. The preferred resins are those having a weight per phenolic group of from 55 to 200, preferably from 60 to 110, and more than 2.5 phenolic hydroxyl groups per molecule. Such resorcinol novolacs are available commercially under the tradename Penacolite® from Koppers. Component (b) will be present in the composition in an amount effective to cure the epoxy resin system, generally from 10 to 50 %w, preferably from 20 to 30 %w, based on the weight of total composition of the invention. The ratio of total epoxy equivalents to total resorcinolic hydroxyl equivalents may vary in between 0.2:1 and 2:1.

Suitable urea catalysts forming component (c) include those described by the formula

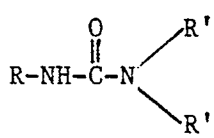

where R and R' are hydrogen or substituted or unsubstituted hydrocarbyl. Preferably, R is $C_1$-$C_{20}$ aliphatic or aromatic hydrocarbyl, including methyl, ethyl, propyl, benzyl, tolyl, and the like, and each R' is selected independently from $C_1$-$C_6$ alkyl and cycloalkyl. Examples of such urea-based compounds include urea, butylurea, N-(p-chlorophenyl)-N',N'-dimethylurea, and phenylurea. Suitable urea-based catalysts also include polyureas such as the reaction product of a polyaryl polyisocyanate with a dialkyl amine. The presently preferred urea catalyst is N-phenyl-N',N'-dimethylurea, which is commercially available as Fikure

62-U. The urea catalyst can be present in the composition in any amount effective to accelerate the cure of the epoxy resin components. Generally, the urea catalyst component will be present in the composition in an amount within the range of from 0.1 to 5 %w, preferably from 0.8 to 1.5 %w based on the weight of total composition of the invention.

The novel composition can further contain a crosslinkable monomer, preferably a vinyl aromatic monomer. Preferred examples of suitable crosslinkable monomers include styrene, divinylbenzene, ethylvinylbenzene, trimethylolpropane and trimethacrylate. The amount of the crosslinkable monomer present in the composition may vary widely depending upon the properties desired in the final composition, but will generally range in between 0 and 70 %w, preferably about 5 to 20 %w, based on the weight of the epoxy resin component (a).

The invention composition can, for applications such as prepregging, include an organic solvent present in an amount effective to decrease the viscosity of the system for easier processing. Polar organic solvents such as ketones, alcohols and glycol ethers, for example, are suitable. The preferred solvents are ketones such as acetone, methyl ethyl ketone and methyl isobutyl ketone. An advantage of the invention composition is that it is soluble in ketone solvents and does not require more toxic organic solvents for lowering viscosity to the desired prepregging levels. The proportion of solid components in the composition will vary widely, but for prepregging applications the solvent will generally constitute at least about 10 weight per cent of the entire composition, preferably about 20 to about 60 weight per cent.

The "varnish", or prepregging composition including the resin and curing agent in the chosen solvent, is prepared by combining the solid components, with mixing, in the solvent. For a stable varnish, it has been found preferable to follow a mixing procedure in which the phenolic-based components are first added to the solvent, the urea catalyst is then added, and finally the epoxy components are added to the solvent with mixing. An advantage of the present system is that the components can be mixed into a stable solution at room temperature, although heating can be used for faster dissolution of the solid components in the solvent. A solution prepared in this manner has room temperature stability up to 8 months, which is a significant advantage for the invention system, which can be pre-formulated, stored and shipped to the site of prepregging rather than requiring formulation at the site of prepregging, which is often inconvenient or not feasible.

For preparation of reinforced laminates from the varnish, a substrate, of glass, carbon, quartz, polyaramide, polyester or like materials, in chopped, mat or woven form, is first impregnated with the varnish. A prepreg is formed by heating the impregnated substrate in a press or autoclave at a temperature sufficient to remove the solvent and to partially cure without gelation, the composition of the invention, generally 40 °C to 180 °C, preferably 150 °C to 175 °C, for a time of up to 10 minutes, preferably 0.5 to 2 minutes. The prepreg prepared from the invention system is stable at room temperature for at least six months after the prepregging process. A laminate is fabricated from one or more prepregs by subjecting a set of layered prepregs to conditions effective to cure the epoxy resins and to integrate the prepregs into a laminate. The laminate can optionally include one or two outer layers of a conductive materials such as copper. Such conditions generally include a time of from 1 to 4 hours, preferably from 0.5 to 2 hours, at a temperature of from 160 °C to 300 °C. The composition can also include further optional constituents such as inorganic fillers and colouring agents.

## EXAMPLE

A solution of 12 %w (based on total weight of the composition of the invention) Penacolite B19S (a condensate of resorcinol, formaldehyde and mixed di- and tri-hydroxyphenyls), 5 %w tetrabromobisphenol-A and 0.01 %w N-phenyl-N′,N′-dimethylurea curing agent in a solution blend of 19 %w methyl n-amyl ketone and 11 %w methyl isobutyl ketone was prepared by stirring the constituents together at about 70 °C. 38 %w of EPIKOTE 1031 and 16 %w of the diglycidyl ether of tetrabromobisphenol-A were added with stirring. The resulting composition, which had a solids content of 59 %w, had a viscosity of 1.40 poise.

A prepreg was prepared by impregnating a fiberglass mat with the above epoxy system in approximately a 1:1 weight ratio of varnish to glass. The impregnated glass was heated in a hot-air convection oven at 163 °C for about 4.5 minutes.

An 8-ply laminate was then prepared from 8 prepregs cured in a press at 200 °C and 200 psi for 60 minutes. The laminate had the properties shown in the Table.

TABLE

Laminate Properties

| | |
|---|---|
| Normal Thickness, In. | 0.052 |
| Flexural Strength, 23 °C, 0.07 $kg/cm^2$ | 62,000 |
| Flexural Modulus, 23 °C, 0.07 $kg/cm^2$ | 2,771,200 |
| Peel Strength, 23 °C, Copper Before and After Thermal Stress, 0.5 kg/25 mm | 8.0 |
| Dielectric Constant, 23 °C, D-24/23 | 4.05 |
| Dissipation Factor, 23 °C, D-24/23 | 0.014 |
| Dielectric Strength, 23 °C, Volts/Mil | 800 |
| Volume Resistivity, ohms at 500 Volts | $3.0 \times 10^{16}$ |
| Surface Resistivity, ohms at 500 Volts | $1.1 \times 10^{16}$ |
| Flammability, UL-94 | V-0 |
| Tg by DSC, °C | 235 |

## Claims

**1.** A composition comprising:

(a) an epoxy resin having an average functionality of from 3 to 6;
(b) a curing amount of a resorcinol novolac resin;
(c) a catalytic amount of a urea compound described by the formula

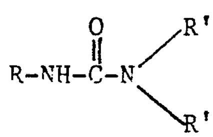

in which R is an aromatic or aliphatic moiety and each R' is selected independently from $C_1$-$C_{20}$ alkyl and aromatic;
(d) a halogenated epoxy resin having an average functionality of from 2 to 3;
(e) a halogenated bisphenol.

**2.** The composition of claim 1 in which epoxy resin component (a) has an average functionality of from 3.5 to 4.5.

**3.** The composition of claim 1 or 2 in which the urea compound has the formula

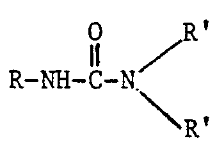

in which R is aromatic and each R' is selected independently from methyl and ethyl.

4. The composition of claim 1 in which epoxy resin component (a) is a tetrafunctional polyglycidyl ether of tetrakis(hydroxyphenyl) ethane.

5. The composition of any of claims 1-4 in which component (d) is a polyglycidyl ether of tetrabromobisphenol-A.

6. The composition of any one of claims 1 to 5 which further comprises a vinyl monomer selected from styrene, divinylbenzene, ethylvinylbenzene, and trimethylolpropane trimethacrylate.

7. The composition of any one of claims 1 to 6 in which component (e) is tetrabromobisphenol-A.

8. The composition of any one of claims 1 to 3 in which epoxy resin component (a) is present in the composition in an amount of about 20 to about 60 weight per cent, based on the total weight of the components.

9. An electrical laminate comprising the cured composition of claim 1 and a fibrous reinforcing agent.

**Revendications**

1. Composition qui comprend :
   (a) une résine époxy ayant une fonctionnalité moyenne comprise entre 3 et 6 ;
   (b) une quantité de durcissement d'une résine résorcinol-novolaque ;
   (c) une quantité catalytique d'un composé urée décrit par la formule

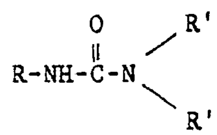

   dans laquelle R est un fragment aromatique ou aliphatique et chaque R' est choisi de manière indépendante parmi un groupe aromatique et alkyle en $C_1$-$C_{20}$ ;
   (d) une résine époxy halogénée ayant une fonctionnalité moyenne comprise entre 2 et 3 ;
   (e) un bisphénol halogéné.

2. Composition selon la revendication 1, dans laquelle le composant résine époxy (a) possède une fonctionnalité moyenne comprise entre 3,5 et 4,5.

3. Composition selon la revendication 1 ou 2, dans laquelle le composé urée possède la formule

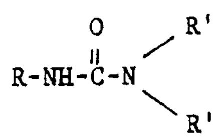

dans laquelle R est un groupe aromatique et chaque R' est choisi de manière indépendante parmi un groupe méthyle et éthyle.

4. Composition selon la revendication 1, dans laquelle le composant résine époxy (a) est un éther polyglycidylique tétrafonctionnel de tétrakis(hydroxyphényl)éthane.

5. Composition selon l'une quelconque des revendications 1 à 4, dans laquelle le composant (d) est un éther polyglycidylique de tétrabromobisphénol-A.

6. Composition selon l'une quelconque des revendications 1 à 5, qui comprend en outre un monomère vinylique choisi parmi le styrène, le divinylbenzène, l'éthylvinylbenzène et le triméthacrylate de triméthylolpropane.

7. Composition selon l'une quelconque des revendications 1 à 6, dans laquelle le composant (e) est le tétrabromobisphénol-A.

8. Composition selon l'une quelconque des revendications 1 à 3, dans laquelle le composant résine époxy (a) est présent dans la composition en une quantité allant d'environ 20 à environ 60 pour-cent en poids par rapport au poids total des composants.

9. Plaquette électrique comprenant la composition durcie selon la revendication 1 et un agent de renforcement fibreux.

## Patentansprüche

1. Masse, enthaltend:
   (a) ein Epoxyharz mit einer mittleren Funktionalität von 3 bis 6;
   (b) eine härtende Menge eines Resorcin-Novolac-Harzes;
   (c) eine katalytische Menge einer Harnstoffverbindung, beschrieben durch die Formel

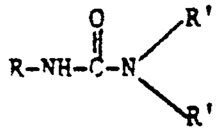

   in der R eine aromatische oder aliphatische Gruppe ist und jedes R' unabhängig ausgewählt ist aus $C_1$-$C_{20}$-Alkylgruppen und aromatischen Resten;
   (d) ein halogeniertes Epoxyharz mit einer mittleren Funktionalität von 2 bis 3;
   (e) ein halogeniertes Bisphenol.

2. Masse nach Anspruch 1, wobei die Epoxyharz-Komponente (a) eine mittlere Funktionalität von 3,5 bis 4,5 aufweist.

3. Masse nach Anspruch 1 oder 2, wobei die Harnstoffverbindung die Formel

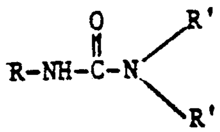

   besitzt, wobei R einen aromatischen Rest bedeutet und jedes R' unabhängig voneinander ausgewählt ist aus Methyl und Ethyl.

4. Masse nach Anspruch 1, wobei die Epoxyharz-Komponente (a) ein tetrafunktioneller Polyalycidylether von Tetrakis(hydroxyphenyl)ethan ist.

5. Masse nach einem der Ansprüche 1 bis 4, wobei die Komponente (d) ein Polyglycidylether von Tetrabrombisphenol-A ist.

6. Masse nach einem der Ansprüche 1 bis 5, umfassend zusätzlich ein Vinylmonomer, ausgewählt aus Styrol, Divinylbenzol, Ethylvinylbenzol und Trimethylolpropan-trimethacrylat.

7. Masse nach einem der Ansprüche 1 bis 6, wobei die Komponente (e) Tetrabrombisphenol-A ist.

8. Masse nach einem der Ansprüche 1 bis 3, wobei die Epoxyharz-Komponente (a) in der Mase in einer Menge von etwa 20 bis etwa 60 Gew.-%, bezogen auf das Gesamtgewicht der Komponenten, vorhanden ist.

9. Elektrisches Laminat, umfassend die gehärtete Masse nach Anspruch 1, und ein faseriges Verstärkungsmittel.